# EUROPEAN PATENT APPLICATION

(11) **EP 4 826 367 A2**
(43) Date of publication of application: **21.10.2026**
(21) Application number: 26200162.1
(22) Date of filing: 28.12.2021
(51) Int. Cl.: G01N 24/08

(54) **TESTING THE AUTHENTICITY OF BIOLOGICAL COMPOSITIONS**

(62) Document number(s) of the earlier application(s) in accordance with Art. 76 EPC: 21020660.3 / 4 206 666
(71) Applicant: Nimbalkar, Manoj, 76189 Karlsruhe (DE)
(72) Inventor: Nimbalkar, Manoj, 76189 Karlsruhe (DE)

(57) **Abstract**

The invention relates to a method for determining a quality characteristic of a composition of biological origin comprising the following steps: a) subjecting the composition to a magnetic field, b) determining a nuclear magnetic relaxation characteristic of the composition and c) comparing the nuclear magnetic relaxation characteristic with a corresponding reference nuclear magnetic relaxation characteristic of at least one reference composition for which the quality characteristic is known, and preferably, d) determining the quality characteristic of the composition from the result of comparing in step c).

## Description

The present invention provides a method, a device, a data analysis system and a software product for determining a quality characteristic of a composition of biological origin.

The present invention relates to the technical field of agricultural and food product analysis and quality assessment.

Different kinds of methods involving the detection of nuclear magnetic signals have been described for deriving information about the contents of agricultural and food products.

German patent DE 10 2004 022 687 B4 describes a Time-Domain-Method for determining the content of at least one component of a sample using a low resolution nuclear magnetic resonance (NMR) pulse spectrometer.

US Patent No. 10,801,979 B2 describes application of low-field nuclear magnetic resonance (LF-NMR) techniques for moisture, sugar, and solids measurement in food products. T₁ and T₂ relaxation time measurement is mentioned. The food products include potatoes and products derived from potatoes.

CN 106324011 A describes a method for determining the freshness of a conditioning aquatic product at low temperature. The method involves low field NMR and an electronic nose as the main measurement tools. Low-field NMR instrument CPMG pulse sequence measurement is suggested for measuring longitudinal relaxation time T₂ of the aquatic products during storage at low temperature. The detection data include the initial time T₂₁ of bound water, the initial time T₂₂ of irreducible water, and the initial time T₂₃ of free water.

EP 0890838 A1 describes a method for selecting eggs, in which the eggs are subjected to an NMR treatment for obtaining an NMR image and the eggs are selected on the basis of the NMR image. This publication further describes an apparatus for processing eggs which includes egg supply means, egg selection means, and egg discharge means, the egg selection means comprising at least one apparatus for making at least one NMR image of an egg, and means being provided for controlling the egg discharge means on the basis of the at least one NMR image. This publication further describes comparisons of, for instance, the amplitudes of one or more echo signals, relaxation times and/or relaxation velocities and the like, as well as other processing methods, conventional and known as such, for signals coming from NMR, for instance Magnetic Resonance Imaging (MRI).

An example from EP 0890838 A1 was carried out in an NMR apparatus with a probe diameter of 4.5 cm, and a magnetic field of 0.5 Tesla (22.3 MHz), at a repetition time of 1500 ms and a TEI of 45 ms. Various computer calculations were performed on the signals. It was found that very clear differences are observable in the MRI images of fertilized and unfertilized eggs as a result of differences in T1 and T2 relaxation times. These differences were visualized using an MRI image.

While EP 0890838 A1 is focused on determining if an egg is fertilized or not, WO 00/01302 A1 describes a method and an apparatus for avian pre-hatch sex determination. This publication makes use of a non-invasive imaging method, such as NMR, to make the sex determination. The method comprises irradiating the sex organs of the embryo while within the egg with waves of radiation without damaging the embryo to produce a detectable response or signal. According to WO 00/01302 A1, an imaging means is provided which can further comprise a video screen which displays an image of the sex organs.

WO 2019/092267 A1 describes a method of automated noninvasive determination of the fertility of a bird's egg. The method comprises the following steps: conveying a plurality of bird eggs sequentially or in parallel into an NMR apparatus, subjecting the bird eggs to an NMR measurement, such as to generate a 3-D NMR image of at least a part of each of said eggs, said 3-D NMR image having a spatial resolution in at least one dimension of 1.0 mm or less, preferably of 0.50 mm or less, wherein said part of the egg includes the germinal disc of the respective egg. Sex determination of an egg is mentioned in connection with an apparatus described in this publication and in connection with prior art cited therein.

The above-described known methods for determining the sex of an embryo in a fertilized egg require the generation and analysis of magnetic resonance images.

There is a desire for determining the sex of a fertilized egg even earlier and before sex specific structural features are imageable in the egg. After development has reached a certain stage, it will be unethical to kill the embryo. There is thus a need for simpler non-invasive methods for determining the sex of an egg as early as possible after fertilization. Such methods would enable a more ethical further use of male fertilized eggs in the earliest stages of their embryonic development, while female eggs are selected for breeding. Any incubation of male eggs should be avoided from the outset if there is no economically viable way to use the male chicks. This will avoid the unfortunate but still common unethical killing of male chicks shortly after hatching.

Another issue concerning chicken and eggs is the conditions under which chicken are being held in egg production. Eggs are often labelled such that a consumer can read farming conditions from the egg. The European Union, for example, has defined an egg code that includes a number indicating the method of production. According to this code, "0" indicates organic egg production, "1" indicates free-range eggs, "2" indicates deep litter indoor housing, and "3" indicates cage farming. To the best of the inventor's knowledge, there is no simple, reliable and non-destructive method for controlling if an indication on an egg is correct.

A problem underlying the invention is to overcome the disadvantages of the state of the art concerning the determination of egg sex and/or egg farming conditions. More specifically, the problem underlying the invention is the provision of a non-destructive, simple and reliable method and device for determining a quality characteristic of an egg, e.g., a farming condition of egg production or the sex of a fertilized egg.

In addition to the above problems related to eggs, there is a great desire for determining if the quality of a composition of biological origin, such as the quality of a food product, is as claimed by the producer or distributer. This holds true for a huge variety of different composition of biological origin (such as egg, fish, olive or honey), that are present in various states, ranging from essentially liquid to solid.

A more general problem underlying the invention is thus the provision of a non-destructive, versatile, simple and reliable method and device capable of assessing a quality characteristic of a broad range of compositions of biological origin.

This problem is solved by the methods, devices, data analysis systems and software products as defined in the claims.

The method of the invention for determining a quality characteristic of a composition of biological origin comprises the following steps: a) subjecting the composition to a magnetic field, b) determining a nuclear magnetic relaxation characteristic of the composition, and c) comparing the nuclear magnetic relaxation characteristic with a corresponding reference nuclear magnetic relaxation characteristic of at least one reference composition for which the quality characteristic is known, and preferably, d) determining the quality characteristic of the composition from the result of comparing in step c).

The term "composition" is used in its broadest sense. Any matter of biological origin such as an olive, an egg, a fish, meat or a fruit is composed of many different components and therefore a composition. The method of the invention can be applied to a very broad range of compositions of biological origin.

Without wishing to be bound by theory, the inventor assumes that compositions of biological origin are in general accessible to the determination of a quality characteristic by the method and device of the invention. This is because the underlying nuclear magnetic relaxation phenomenon exists and is detectable in any such composition.

Typical compositions of biological origin comprise biological cells and/or destroyed biological cells. It is assumed that water based and/or lipid based contents of biological cells allow for the use of the method and device according to the invention.

A specific example of a composition of biological origin that is accessible to the determination of a quality characteristic according to the invention is a bird egg, an unfertilized bird egg, a fertilized bird egg, a fish, a fish product, an oil fruit, an oil fruit based product, a honey, a soy, a soy product, a milk, a milk product, a meat, a meat based product, a fruit, a fruit based product.

The term "quality characteristic" may relate to any desired or undesired state of the composition of biological origin under investigation. In view of the broad variety of compositions that are accessible to the invention, it is understood that different quality characteristics may be important for different compositions under investigation. For some compositions like fish products, a key quality characteristic is continuous cooling, i.e. if the fish product was kept in a frozen state without interruption, or not. Other quality characteristics may be important for other compositions. For a fertilized bird egg, for example, the key quality characteristic is the sex of the fertilized bird egg.

The quality characteristic may, for example, be a farming condition under which the composition of biological origin was produced (e.g. non - bio eggs labeled as bio eggs), a sex (e.g., in the case of a fertilized egg), a thermal history, for example if a composition was continuously kept in a frozen state, or not (e.g. Frozen fish sold as fresh fish), a maturity level, a pesticide exposure, a substitution (e.g. Beef meat substituted by Horse meat), an adulteration (e.g. Melanin was being added to milk and infant formula), a geographical origin (e.g. tracing the origin of meat like Wagyu from Japan or Europe), or a nutrient content of a food (e.g. fat, water and protein percentage in food).

The composition of biological origin is, for example
- a bird egg and the quality characteristic is a farming condition under which the egg was produced, or
- a fertilized egg and the quality characteristic is a sex of the fertilized egg, or
- a fish or a fish product and the quality characteristic is the thermal history of the fish or fish product, e.g., if the fish or fish product was continuously kept in a frozen state, or not, or it is fresh, or
- an oil fruit or an oil fruit based product and the quality characteristic is a maturity level of the oil fruit or a grade of the oil fruit based product, or
- a honey and the quality characteristic of the honey is a pesticide exposure of the bees in the area in which bees have collected constituents of the honey, or
- a soy or a soy product and the quality characteristic is a farming condition under which the soy or soy used for the soy product was produced, (the quality characteristic of the soy or a soy product may, for example, include a protein content and/or a water content), or
- a milk or a milk product and the quality characteristic is a farming condition under which the milk or milk used for the milk product was produced, or
- a meat or a meat based product and the quality characteristic is a farming condition under which the meat or meat used for the meat based product was produced (the farming condition under which the meat or meat used for the meat based product was produced may include, for example, origin, type, storage conditions), or
- a fruit or a fruit based product and the quality characteristic is a farming condition under which the fruit or fruit used for the fruit based product was produced (the farming condition under which the fruit or fruit used for the fruit based product was produced may include, for example, origin, type, storage conditions).

According to step a), the composition is subjected to a magnetic field. Preferably, the composition is subjected to a magnetic field by transporting the composition into the magnetic field. In specific methods of the invention, where the magnetic filed is the earth magnetic field, subjecting the composition to the magnetic field does not require any activity as the composition is already in the magnetic field.

Typically, the magnetic field mentioned herein is stronger than the earth magnetic field. The magnetic field strength is selected such that the ¹H resonance frequency can, for example, be in a range from 0.5 MHz to 20 MHz, e.g. from 0.8 MHz to 15 MHz, preferably from 1 MHz to 10 MHz. Higher magnetic field strengths such as those requiring superconducting magnets can be applied. However, it has been found that magnetic field strengths of common permanent magnets and common electromagnets are well sufficient for the method according to the invention. This enables a very widespread use of the technology according to the invention non-laboratory surroundings and where very cost-efficient methods and devices are requires, e.g. close to food production sites, in food distributing or food importing companies, etc.

According to the invention, the magnet for generating the magnetic field can, for example, be a non-superconducting electromagnet or a permanent magnet, preferably a permanent magnet. Any material which can produce a magnetic field can be used, a future high temperature superconducting magnet can also be used.

The magnetic field as described herein is thus a static magnetic field. This does not exclude the application of magnetic field gradients along the magnetic field which are routinely applied in NMR experiments.

According to step b) of the method of the invention, a nuclear magnetic relaxation characteristic of the composition is determined.

Determination of the nuclear magnetic relaxation characteristic preferably comprises determining an amplitude of a magnetization in the composition while the magnetization in the composition recovers towards equilibrium magnetization in the magnetic field.

Determining an amplitude of a magnetization in the composition typically comprises application of a radiofrequency (RF) pulse. The RF pulse typically is an electromagnetic pulse which is on resonance with NMR active nuclei comprised by the composition and rotates a magnetization in the composition towards or into a plane orthogonal to the magnetic field. The magnetization thus becomes detectable, e.g., by a suitable receiver. This is well-familiar to skilled persons in the field of nuclear magnetic resonance spectroscopy or relaxometry.

Immediately after the composition has been subjected to the magnetic field, the magnetization will not be in equilibrium. The magnetization in the composition thus recovers towards equilibrium magnetization in the magnetic field even without applying any RF pulse to the composition. The nuclear magnetic relaxation characteristic of the composition can be determined from this inherent relaxation. This is less preferred because a gain in sensitivity and precision is achieved if magnetization is disturbed by an initial RF pulse.

Determination of the nuclear magnetic relaxation characteristic typically comprises disturbing magnetization in the composition. Disturbing magnetization in the composition is typically carried out by applying an RF pulse to the composition in the magnetic field, before the amplitude is determined and/or after the amplitude was determined. This RF pulse is preferably applied such that magnetization in the composition is at least partially saturated or inverted.

Step b) preferably comprises performing at least one spin echo while the magnetization recovers towards equilibrium magnetization. It has been found that the spin echo, which may be part of a CPMG pulse train, provides additional information or contrast parameter to improve the prediction of the properties under study, e.g. the prediction of one of the quality characteristics of the composition as described herein.

Preferably, the nuclear magnetic relaxation characteristic of the composition comprises a set of amplitudes of a magnetization measured at a set of different points of time, while the magnetization recovers towards the equilibrium magnetization. The nuclear magnetic relaxation characteristic may thus be described more accurately as a time domain characteristic or as a nuclear magnetic time domain characteristic.

In a very simple embodiment of the method of the invention, the amplitudes of the magnetization are amplitudes of the magnetization measured in the time course of a free induction decay (FID). This is typically less preferred, as a more advanced implementation of the invention allows for a more accurate determination of the quality characteristic of the composition.

The method may therefore include, for example, multiple spin echos and determining the amplitude of the magnetization after multiple spin echos.

Preferably, the nuclear magnetic relaxation characteristic of the composition comprises a set of amplitudes of a magnetization measured at a set of different points of time, while the magnetization recovers towards the equilibrium magnetization and the nuclear magnetic relaxation characteristic of the reference composition comprises a set of corresponding reference amplitudes of a corresponding magnetization of the reference composition measured at a set of corresponding different points of time, while the magnetization of the reference composition recovers towards the equilibrium magnetization.

This set of amplitudes is a unique fingerprint of the respective composition under investigation. This fingerprint will be different if the respective quality characteristic is met by a composition under investigation and resemble the reference fingerprint of the reference composition for which the same quality characteristic is known. This allows a user to create a unique set of data for a data base for the targeted analysis such as distinguishing between frozen fish and chilled fish or bio eggs and non-bio eggs.

The set of amplitudes is preferably a set of at least 2, preferably at least 4, e.g. at least 20, in particular at least 100 amplitudes, and the set of reference amplitudes is a set of at least 2, preferably at least 4, e.g. at least 20, in particular at least 100 reference amplitudes. In specific cases when the compositions that have the quality characteristic differ very strongly from those compositions that do not have the quality characteristic, a small set of amplitudes may provide sufficient accuracy. However, when the presence of the quality characteristic has only a relatively weak effect on the composition, a much larger set of amplitudes may be required in order to provide sufficient accuracy for a precise decision about the presence or absence of the quality characteristic.

The invention is not limited to nuclear magnetic relaxation characteristics but may include non-nuclear magnetic characteristics. A non-nuclear magnetic characteristic of the composition can be determined in addition to the nuclear magnetic relaxation characteristic of the composition and the non-nuclear magnetic characteristic of the composition can also be used for determining the quality characteristic of the composition. The non-nuclear magnetic characteristic of the composition can be a shape (e.g., a shape of an egg when the composition is an egg), an interaction with electromagnetic waves, e.g. an absorption of light, in particular an absorption of infrared light or ultra violet light or a physiochemical property such as sample temperature, color, viscosity, density, texture, appearance, pH, etc.

One key advantage of the invention is the ability of determining the quality characteristic of the composition without a need for determining a content of a specific constituent comprised by the composition. This is an important difference to the techniques described in German Patent DE 10 2004 022 687 B4. According to the invention, the nuclear magnetic relaxation characteristic turned out to be a fingerprint that reflects the complexity of the composition in a complex fingerprint which is fully sufficient for determining if the composition has a certain quality characteristic or not.

A preferred method of the invention does not comprise quantifying a content of a specific component of the composition. Nevertheless, the method could be altered or optimized to also include a determination of a specific content of a constituent comprised by the composition.

The method of the invention typically does not involve a transformation from the time domain into a frequency domain. It is thus different from NMR spectroscopy.

A great advantage of the invention over well-known NMR spectroscopy based metabolomics approaches - that might also be useful for determining quality characteristics of specific compositions as mentioned herein - is the ability of implementing it with lower magnetic field strengths. NMR spectroscopy based metabolomics typically requires very strong magnetic fields corresponding to resonance frequencies of ¹H nuclei of 500 MHz or even higher. The invention mainly relies on nuclear magnetic relaxation properties that can be derived at much lower frequencies, i.e. at much smaller magnetic field strengths that do not require superconductors cooled by liquid helium and thus can be carried out in common permanent magnets or common electro magnets. The costs of a magnet required for the invention are thus one or two orders of magnitude lower than the costs for a magnet that would be required for obtaining similar information by NMR based metabolomics.

According to the invention, a strength of the magnetic field may correspond to a resonance frequency of ¹H nuclei of not more than 60 MHz, most preferably not more than 20 MHz.

The reference nuclear magnetic relaxation characteristic of at least one reference composition for which the quality characteristic is known preferably involves a first set of reference nuclear magnetic relaxation characteristics of a set of first reference compositions, wherein each of the first reference compositions has the quality characteristic. It preferably involves a second set of reference nuclear magnetic relaxation characteristics of a set of second reference compositions, wherein each of the second reference compositions does not have the quality characteristic. The first and second set of reference nuclear magnetic relaxation characteristics are preferably stored on a data analysis system. Such two sets of nuclear magnetic relaxation characteristics allow for a more accurate determination of the quality characteristic of a composition of biological origin.

Determining the quality characteristic of the composition from the result of comparing is preferably based on a similarity of the nuclear magnetic relaxation characteristic with the corresponding reference nuclear magnetic relaxation characteristic. This similarity can be quantified by well-known computational methods which may include, for example, Monte Carlo methods, Support Vector Machines, and/or Artificial Neural Networks etc. The computational methods may alternatively or in addition include Artificial Intelligence methods and/or machine learning methods. Artificial intelligence algorithms may, for example, be used in specific combination of machine learning methods such as regression, classification, and ensemble methods.

The invention further relates to a data analysis method for determining a quality characteristic of a composition of biological origin from comparing a nuclear magnetic relaxation characteristic as described herein with a corresponding reference nuclear magnetic relaxation characteristic of at least one reference composition for which the quality characteristic is known, as further described herein.

The invention further relates to a computational system or software product. The computational system or software product is configured for executing the data analysis method.

The invention further relates to a device for determining a quality characteristic of a composition of biological origin, comprising
a magnet for generating a magnetic field,
a transporting means for transporting the composition into the magnetic field,
an electromagnetic unit configured
for subjecting the composition in the magnetic field to an RF pulse, and
for determining a nuclear magnetic relaxation characteristic of the composition, e.g. for determining an amplitude of a magnetization in the composition, while the magnetization in the composition recovers towards equilibrium magnetization in the magnetic field,
wherein the device comprises or is connectable to or connected to a data analysis system configured for
comparing the nuclear magnetic relaxation characteristic with a corresponding reference nuclear magnetic relaxation characteristic of at least one reference composition for which the quality characteristic is known, and preferably,
determining the quality characteristic of the composition from the result of comparing.

Any transporting means are suitable that are capable of transporting the composition, e.g. the egg, fish or olive oil, into the magnetic field. A typical transporting means, e.g. a conveyor belt, will comprise receiving sections for the composition of biological origin of interest. If a constituent of the composition is a shell, for example, the shell of an egg, the receiving section of the transporting means may, for example, comprise receiving sections resembling those for holding eggs in an egg carton.

A typical electromagnetic unit comprises a probe. Probes are well-known to skilled persons in the technical field of NMR spectroscopy and relaxometry.

The data analysis system may be part of the device of the invention or at another location with data connection to the device. The device may comprise the data analysis system. The device may instead be connected to the data analysis system.

The invention can be in the form of a data analysis method, a data analysis system or a software product, which is suitable for handling the data typically acquired using the methods and devices as described hereinabove.

Thus, the invention further relates to a data analysis method for determining a quality characteristic of a composition of biological origin, comprising:
comparing a nuclear magnetic relaxation characteristic of a composition of biological origin with a corresponding reference nuclear magnetic relaxation characteristic of at least one reference composition for which the quality characteristic is known, and
determining the quality characteristic of the composition from the result of comparing.

The invention further relates to a data analysis system or software product, wherein the data analysis system or software product is configured for executing the data analysis method.

Any aspect described herein, for example in connection with other methods or in connection with devices of the invention, can also form part of the data analysis method.

The invention is described further by the following non-limiting Figures and examples:
- Figure 1: shows an example of pulse sequence useful for acquiring data from a given sample.
- Figure 2: shows experimental data acquired using the pulse sequence represented in Fig. 2.
- Figure 3: shows experimental data from Fig. 2 which is presented in a matrix form.
- Figure 4A: represents the software implementation of the processing of experimental data according to the invention.
- Figure 4B: shows details about options that can be chosen for the processing of experimental data.
- Figure 5: shows operating steps involved in the manual software operation C-M.
- Figure 6: is a confusion matrix demonstrating the reliability of the invention for the freshness of sample of interest for each sample type.
- Figure 7: is a three dimensional projection of the discrimination model space. It shows the ellipsoids of probability for each source of sample of interest. The sample of interest represented by a filled square box and modelling sample represented by filled circles for each sample type.

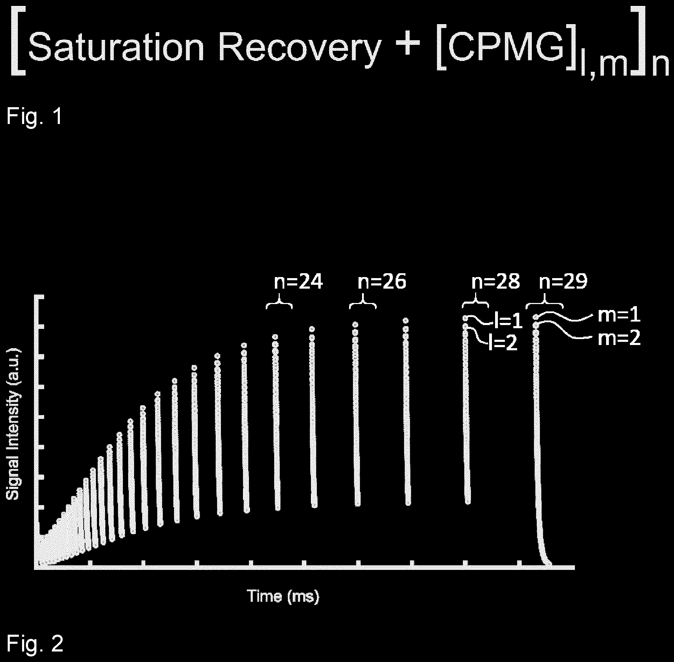

Figure 1 depicts a specific example of an RF pulse sequence that can be used for step b) of the method according to the invention, i.e. for determining a nuclear magnetic relaxation characteristic of a composition.

This is one non-limiting example of a pulse sequence that enables determining an amplitude of a magnetization in the composition while the magnetization in the composition recovers towards equilibrium magnetization in the magnetic field.

In this specific example, the pulse sequence involves a saturation recovery, as indicated in Figure 1. The magnetization thus recovers after an initial saturation towards an equilibrium magnetization in the magnetic field. Saturation recovery is well know to those skilled in the art of NMR spectroscopy and relaxometry. The methodology and theory of saturation recovery has been considered in detail in the literature: (Abragam, A. (1961). "VII Thermal Relaxation in Liquids and Gases". Principles of Nuclear Magnetism. Oxford University Press. p. 264). Malcolm H. Levitt: Spin Dynamics: Basics of Nuclear Magnetic Resonance, 2nd edition, John Wiley & Sons, New York 2008. J.H. Freed, L.J. Berliner (Ed.), Spin Labeling Theory and Applications, vol. 1, Academic Press, New York (1976), pp. 53-132. P.W. Percival, J.S. Hyde, Saturation-recovery measurements of the spin-lattice relaxation times of some nitroxides in solution, J. Magn. Reson., 23 (1976), pp. 249-257. Robinson BH, Haas DA, Mailer C. Molecular dynamics in liquids: spin-lattice relaxation of nitroxide spin labels. Science. 1994; 263:490-493).

The specific RF pulse sequence depicted in Figure 1 further involves multiple Carr-Purcell-Meiboom-Gill (CPMG) pulse trains that are applied while the initially saturated magnetization recovers towards equilibrium. The number of CPMG pulse trains is indicated by index "n". Each CPMG pulse train is initiated by a 90 degree RF pulse that rotates the (partially recovered) magnetization in a plane perpendicular to the magnetic field.

The CPMG pulse train is a fundamental component of RF pulse sequences used for the measurement of dynamic processes by NMR spectroscopy. The initial 90 degree RF pulse is followed by a sequence of 180 degree RF pulses that can be abbreviated by ${\left(t-180°-t\right)}_{/ or m}$ wherein
- 180°: is the 180 degree RF pulse, and
- t: is a delay and
- I or m: are indices that are also shown in Figure 1 and which indicate the number of repetitions of (*t-*180°-*t*) within the CPMG pulse train.

The delay t is generally described as a spin-echo delay and the 180 degree RF pulse is commonly described as a refocusing pulse in the literature.

The methodology and theory of CPMG has been considered in detail in the literature: (2013) Carr-Purcell-Meiboom-Gill Spin Echo. In: Roberts G.C.K. (eds) Encyclopedia of Biophysics. Springer, Berlin, Heidelberg. https://doi.org/10.1007/978-3-642-16712-6_100136.

Abragam, A. (1961). "VII Thermal Relaxation in Liquids and Gases". Principles of Nuclear Magnetism. Oxford University Press. p. 264.

Malcolm H. Levitt: Spin Dynamics: Basics of Nuclear Magnetic Resonance, 2nd edition, John Wiley & Sons, New York 2008.

Carr, H. Y.; Purcell, E. M. (1954). "Effects of Diffusion on Free Precession in Nuclear Magnetic Resonance Experiments". Physical Review. 94 (3): 630-638.

Hahn, E.L. (1950). "Spin echoes". Physical Review. 80 (4): 580-594.

Malcolm H. Levitt; Ray Freeman (1979). "NMR population inversion using a composite pulse". Journal of Magnetic Resonance. 33 (2): 473-476).

As pointed out in the more general description of the invention, step b) in this specific example thus comprises performing many spin echoes while the magnetization recovers towards equilibrium magnetization.

In the specific method of the invention as illustrated by Figures 1, 2, and 3, the nuclear magnetic relaxation characteristic of the composition comprises a set of amplitudes of a magnetization measured at a set of different points of time, while the magnetization recovers towards the equilibrium magnetization. This is achieved in this specific example by distributing n = 29 CPMG pulse trains throughout the T₁ relaxation process and by measuring and recording each amplitude of the magnetization present after every single spin echo within each CPMG pulse train. In Figure 2 the amplitudes of magnetizations are plotted for all the different points of times of detection after the corresponding spin echo in the CPMG pulse train. For the sake of easier understanding, in Figure 2, indices n and m or l are indicated for selected amplitudes of magnetizations. The amplitude of magnetization is referred to on the vertical axis of Figure 2 as "Signal Intensity (a.u.)". The last CPMG pulse train (n=29) was extended, and 500 amplitudes were detected after each of 500 spin echoes. Therefore, only for this last pulse train index "m" is used instead of index "I".

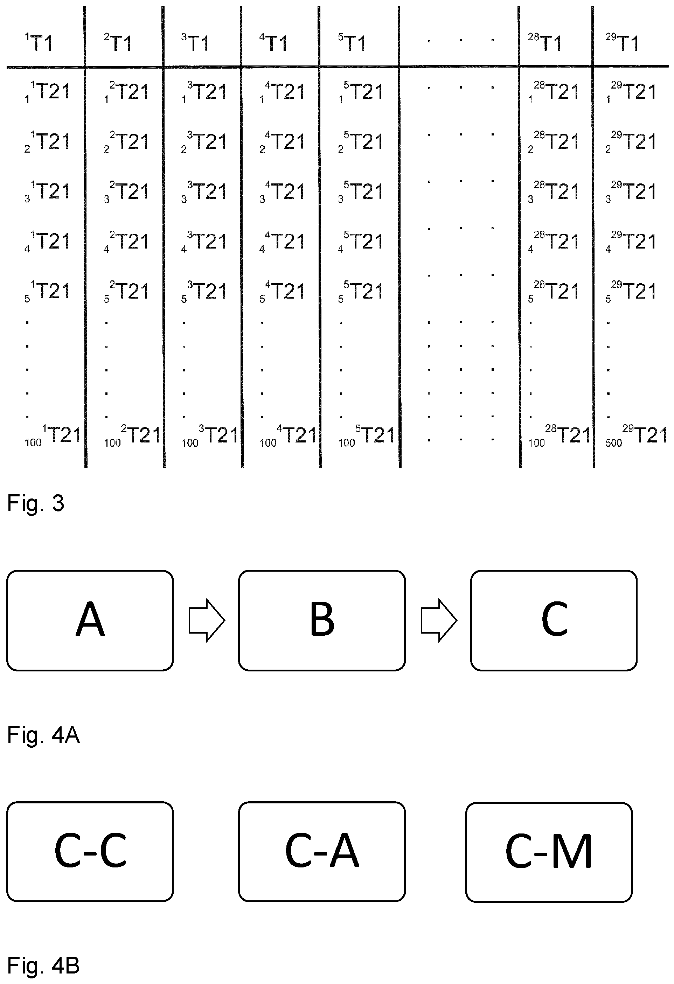

This is also understood from Figure 3 which represents the amplitudes of magnetizations from Figure 2 in the form of a matrix. The amplitudes of magnetizations are arranged in lines and columns. In the left most column are the amplitudes of magnetizations which were detected within the first CPMG pulse sequence (n=1), with the first amplitude of magnetization detected in this CPMG pulse train at the top (l=1) and the last amplitude of magnetization detected in this CPMG pulse train at the bottom (l=100). Amplitudes of magnetizations detected in subsequent CPMG pulse trains are in the following columns. The amplitudes of magnetizations detected in the last CPMG pulse train are thus in the right most column.

Every amplitude of a magnetization as shown in Figures 2 and 3 is thus governed by T1 and by T2 relaxation processes which are unique for every composition under investigation.

In Fig. 4A, left panel A represents sample data from the analytical instrument. Middle panel B represents the backend of the program which depicts reference dataset and algorithm based on the principals of Principal Component Analysis (PCA) and/or Artificial Neural Networks (ANN) and/or Monte Carlo and/or Artificial Intelligence (AI) or Machine Learning (ML) based algorithm. The right panel represents the front end of the software to depict operation mode to be chosen and result display. More details with regard to the right panel and the operation modes to be chosen are shown in Fig. 4B.

Fig. 4B shows the software option to be chosen C-A (automatic) or C-M (manual).

C-A: In the automatic option, new data just acquired by user while operating an instrument is detected and results is displayed as per users need such as origin, type, freshness.

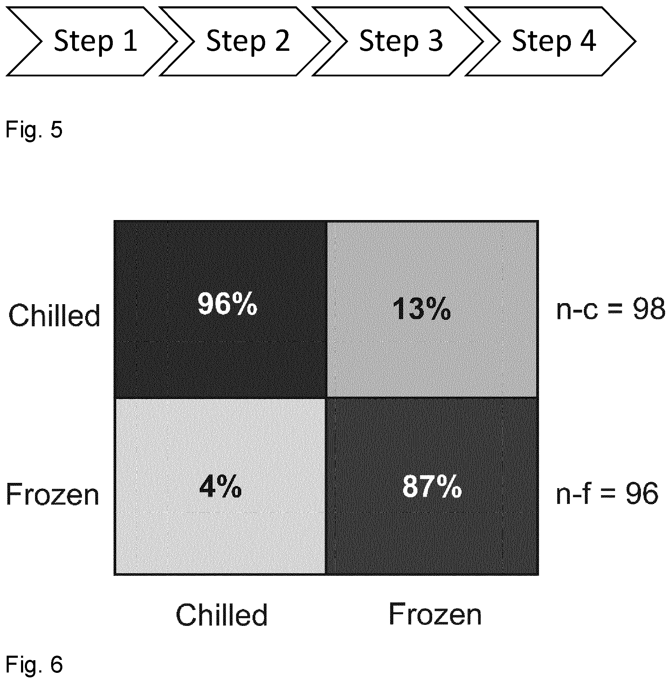

C-M: In the manual option, the user and/or operator of the instrument choses the dataset saved in the system folder as an input the software. The software analyses the enter data and provide the results as per users need such as origin, type, freshness. The process is described in the Figure 5.

Fig. 5 shows the operating steps involved in the manual software operation C-M by the user.

Step 1: Open the software by clicking on the software icon on the PC or system.

Step 2: Select the data set from the folder as an input for the software to be analyzed.

Step 3: The result is displayed for the selected data.

Step 4: User and/operator can choose to display the customized infographics of the datasets analyzed till date.

Figure 6 represents a confusion matrix between frozen and chilled fish. The confusion matrix shows the fidelity of the experimental results, where n-f is number frozen and n-c chilled samples. The underlying mathematical methods and their applications have been described elsewhere in detail:
Kent J.T., Bibby J.M., Mardia K.V. Multivariate Analysis. Academic Press Inc.; Maryland Heights, MO, USA: 1980.
Eugene S.T. Randomization Tests. Marcel Dekker Ltd; New York, NY, USA: 1995.
Hastie T, Tibshirani R, Friedman J (2009) The elements of statistical learning. In: Data mining, inference, and prediction, 2nd edn. Springer series in statistics. Springer
Mohammadi M, Midi H, Arasan J, Al-Talib B. High breakdown estimators to robustify phase II multivariate control charts. J Appl Sci. 2011;11:503-511. doi: 10.3923/jas.2011.503.511.
Pomerantsev AL. Acceptance areas for multivariate classification derived by projection methods. J Chemometrics. 2008;22:601-609. doi: 10.1002/cem.1147.
Vanderginste BGM, Massart DL, Buydens LMC et al (1998) Handbook of chemometrics and qualimetrics: Part B. Elsevier.

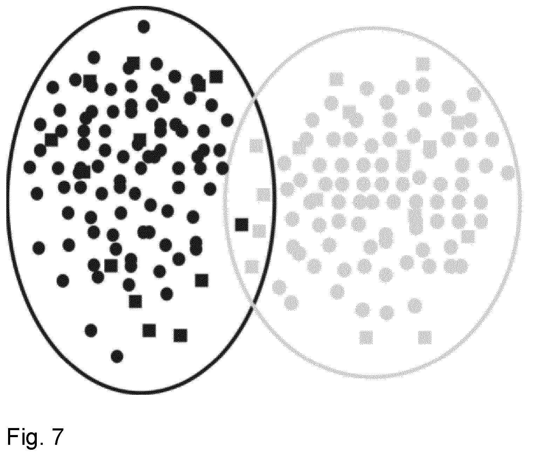

Figure 7 shows a three-dimensional projection of the discrimination model space. It shows the ellipsoids of probability for each source of sample of interest (Chilled fish data represented by dark filled square and circles on left of the figure and frozen fish data represented by grey filled square and circles on right). The composition (here: fish sample) of interest represented by a filled square and the reference composition (here: reference fish sample) represented by filled circles for each sample type. The underlying mathematical methods and their applications have been described elsewhere:
Aygen, S., Dürr, U., Hegele, P., Kunig, J., Spraul, M., Schäfer, H., Krings, D., Cannet, C., Fang, F., Schütz, B., Bülbül, S. F., Aydin, H. I., Sarici, S. U., Yalaz, M., Ors, R., Atalan, R., & Tuncer, O. (2014). NMR-Based Screening for Inborn Errors of Metabolism: Initial Results from a Study on Turkish Neonates. JIMD reports, 16, 101-111. https://doi.org/10.1007/8904_2014_326
Rinke P., Moitrier S., Humpfer E., Keller S., Moertter M., Godejohann M., Hofmann G., Schaefer H., Spraul M. An 1H-NMR-Technique for high throughput screening in quality and authenticity control of fruit juice and fruit raw materials. Fruit Process. 2007;17:10-18
Spraul, M., Schütz, B., Rinke, P., Koswig, S., Humpfer, E., Schäfer, H., Mörtter, M., Fang, F., Marx, U. C., & Minoja, A. (2009). NMR-based multi parametric quality control of fruit juices: SGF profiling. Nutrients, 1(2), 148-155. https://doi.org/10.3390/nu1020148
Lachenmeier D., Humpfer E., Fang F., Schütz B., Dvortsak P., Sproll C., Spraul M. NMR-Spectroscopy for nontargeted screening and simultaneous quantification of health-relevant compounds in foods: The example of melamine. J. Agric. Food Chem. 2009;57:7194-7199.
Lachenmeier, D. W., Humpfer, E., Fang, F., Schütz, B., Dvortsak, P., Sproll, C., & Spraul, M. (2009). NMR-spectroscopy for nontargeted screening and simultaneous quantification of health-relevant compounds in foods: the example of melamine. Journal of agricultural and food chemistry, 57(16), 7194-7199. https://doi.org/10.1021/jf902038j

It has previously been shown that ¹H NMR spectra of samples provide sufficient details for identifying mislabelled eggs (Ackermann et al., NMR-based differentiation of conventionally from organically produced chicken eggs in Germany, Magn Reson Chem. 2019; 57: 579-588). The approach described in this publication applies Principal component analysis (PCA) to ¹H NMR data, followed by a linear discriminant analysis (PCA-LDA) and Monte Carlo cross-validation.

Additionally, a quantitative analysis of NMR proton relaxation (operating at proton frequencies of 23.4 and 300.15 MHz) in hen egg albumen and yolk has been demonstrated to research the causes of quality loss during the first few days of storage and to access the feasibility of an on-line NMR sensor of internal egg quality. The analysis was destructive (Laghi L, Cremonini MA, Placucci G, Sykora S, Wright K, Hills B. A proton NMR relaxation study of hen egg quality. Magn Reson Imaging. 2005 Apr;23(3):501-10. doi: 10.1016/j.mri.2004.12.003. PMID: 15862652).

The inventor has found that the same type of data analysis can be applied using the NMR Relaxometry dataset as shown in Figures 2 and 3 as input data instead of¹H NMR spectra. This has great advantages as the eggs (or other samples or compositions of interest) do not have to be destroyed and the NMR instrumentation required for the intention is much less costly. The present invention can be carried out in magnetic fields that can be generated with conventional permanent magnets or conventional electromagnets instead of the very costly superconducting magnets. The latter are required in prior art approaches that are based on high resolution ¹H NMR spectra.

## Claims

1. A method for determining a quality characteristic of a composition of biological origin comprising the following steps:
a) subjecting the composition to a magnetic field,
b) determining a nuclear magnetic relaxation characteristic of the composition and
c) comparing the nuclear magnetic relaxation characteristic with a corresponding reference nuclear magnetic relaxation characteristic of at least one reference composition for which the quality characteristic is known, and preferably,
d) determining the quality characteristic of the composition from the result of comparing in step c).

2. The method according to claim 1, wherein the composition is
- a bird egg and the quality characteristic is a farming condition under which the egg was produced, or
- a fertilized egg and the quality characteristic is a sex of the fertilized egg, or
- a fish or a fish product and the quality characteristic is the thermal history of the fish or fish product, e.g., if the fish or fish product was continuously kept in a frozen state, or not, or it is fresh, or
- an oil fruit or an oil fruit based product and the quality characteristic is a maturity level of the oil fruit (e.g. free acidity, oil, water content) or a grade of the oil fruit based product, or
- a honey and the quality characteristic of the honey is a pesticide exposure of the bees in the area in which bees have collected constituentts of the honey, or
- a soyor a soy product and the quality characteristic is a farming condition under which the soy or soy used for the soy product was produced, or
- a milk or a milk product and the quality characteristic is a farming condition under which the milk or milk used for the milk product was produced, or
- a meat or a meat based product and the quality characteristic is a farming condition under which the meat or meat used for the meat based product was produced, or
- a fruit or a fruit based product and the quality characteristic is a farming condition under which the fruit or fruit used for the fruit based product was produced.

3. The method according to claim 1 or 2, wherein step b) comprises determining an amplitude of a magnetization in the composition while the magnetization in the composition recovers towards equilibrium magnetization in the magnetic field.

4. The method according to claim 3, wherein step b) comprises disturbing magnetization in the composition, e.g. by applying an RF pulse to the composition in the magnetic field, before the amplitude is determined and/or after the amplitude was determined.

5. The method according to claim 3 or 4, wherein step b) comprises performing at least one spin echo while the magnetization recovers towards equilibrium magnetization.

6. The method according to any of claims 3 to 5, wherein
the nuclear magnetic relaxation characteristic of the composition comprises a set of amplitudes of a magnetization measured at a set of different points of time, while the magnetization recovers towards the equilibrium magnetization and
the nuclear magnetic relaxation characteristic of the reference composition comprises a set of corresponding reference amplitudes of a corresponding magnetization of the reference composition measured at a set of corresponding different points of time, while the magnetization of the reference composition recovers towards the equilibrium magnetization.

7. The method according to claim 6, wherein the set of amplitudes is a set of at least 2 amplitudes, and the set of reference amplitudes is a set of at least 2 reference amplitudes.

8. The method according to any of the preceding claims, wherein a non-nuclear magnetic characteristic of the composition is determined in addition to nuclear magnetic relaxation characteristic of the composition and the non-nuclear magnetic characteristic of the composition is also used for determining the quality characteristic of the composition.

9. The method according to any of the preceding claims, wherein the method does not comprise quantifying a content of a specific component of the composition.

10. The method according to any of the preceding claims, wherein a strength of the magnetic field corresponds to a resonance frequency of ¹H nuclei of not more than 60 MHz, most preferably not more than 20 MHz.

11. The method according to any of the preceding claims, wherein
the reference nuclear magnetic relaxation characteristic of at least one reference composition for which the quality characteristic is known,
involves
a first set of reference nuclear magnetic relaxation characteristics of a set of first reference compositions, wherein each of the first reference compositions has the quality characteristic, and
a second set of reference nuclear magnetic relaxation characteristics of a set of second reference compositions, wherein each of the second reference compositions does not have the quality characteristic,
wherein the first and second set of reference nuclear magnetic relaxation characteristics are preferably stored on a data analysis system.

12. The method according to any of the preceding claims, wherein determining the quality characteristic of the composition from the result of comparing is based on a similarity of the nuclear magnetic relaxation characteristic with the corresponding reference nuclear magnetic relaxation characteristic.

13. Device for determining a quality characteristic of a composition of biological origin, comprising
a magnet for generating a magnetic field,
a transporting means for transporting the composition into the magnetic field,
an electromagnetic unit configured
- for subjecting the composition in the magnetic field to an RF pulse, and
- for determining a nuclear magnetic relaxation characteristic of the composition, e.g. for determining an amplitude of a magnetization in the composition, while the magnetization in the composition recovers towards equilibrium magnetization in the magnetic field,
wherein the device comprises or is connectable to or connected to a data analysis system configured for
c) comparing the nuclear magnetic relaxation characteristic with a corresponding reference nuclear magnetic relaxation characteristic of at least one reference composition for which the quality characteristic is known, and preferably,
d) determining the quality characteristic of the composition from the result of comparing.

14. A data analysis method for determining a quality characteristic of a composition of biological origin, comprising:
comparing a nuclear magnetic relaxation characteristic of a composition of biological origin with a corresponding reference nuclear magnetic relaxation characteristic of at least one reference composition for which the quality characteristic is known, and
determining the quality characteristic of the composition from the result of comparing.

15. A data analysis system or software product, wherein the data analysis system or software product is configured for executing the data analysis method according to claim 14.
